# FASCICULE DE BREVET EUROPEEN

(11) **EP 2 648 010 B1**
(45) Date de publication et mention de la délivrance du brevet: **17.06.2015**
(21) Numéro de dépôt: 13360004.9
(22) Date de dépôt: 03.04.2013
(51) Int. Cl.: G01R 31/02, H02H 3/00

(54) **Procédé de gestion des alarmes en fonction des courants de défaut dans une installation électrique et dispositif de mise en oeuvre dudit procédé**
Verfahren zur Verwaltung von Alarmsignalen in Abhängigkeit von den Fehlerströmen in einer elektrischen Anlage, und Vorrichtung zur Umsetzung dieses Verfahrens
Method for managing alarms in accordance with fault currents in an electrical facility and device for implementing said method

(30) Priorité: 04.04.2012 FR 1253120
(43) Date de publication de la demande: 09.10.2013
(73) Titulaire: Socomec S.A., 67230 Benfeld (FR)
(72) Inventeur: Bernard, Thomas, 67100 Strasbourg (FR); Herr, Pierre-Henri, 67140 Barr (FR); Capot, Marc, 67730 Chatenois (FR)
(74) Mandataire: Koelbel, Caroline

(56) Documents cités:
- EP-A1- 0 407 310
- DE-A1- 10 125 529
- DE-A1- 19 826 410
- DE-B3- 10 251 001
- DE-U1- 29 705 187
- US-B1- 6 546 342
- NORMANN FISCHER ET AL: "Analysis of an Autotransformer Restricted Earth Fault Application", PROTECTIVE RELAY ENGINEERS, 2008 61ST ANNUAL CONFERENCE FOR, IEEE, PISCATAWAY, NJ, USA, 1 avril 2008 (2008-04-01), pages 423-435, XP031249267, ISBN: 978-1-4244-1949-4

## Description

### Domaine technique :

La présente invention concerne un procédé de gestion des alarmes en fonction des courants de défaut dans une installation électrique, dans lequel on mesure en permanence le courant de défaut différentiel de ladite installation électrique par un capteur de courant différentiel et le courant de défaut à la terre de ladite installation électrique par un capteur de courant de fuite à la terre, on compare chaque courant de défaut mesuré à un seuil de courant de défaut admissible et, en cas de dépassement dudit seuil, on déclenche une alarme.

L'invention concerne également un dispositif de mise en oeuvre du procédé de gestion décrit ci-dessus, comportant un capteur de courant différentiel agencé pour mesurer en permanence le courant de défaut différentiel de ladite installation, un capteur de courant de fuite à la terre agencé pour mesurer en permanence le courant de défaut de fuite à la terre, un module de contrôle agencé pour comparer chaque courant de défaut mesuré à un seuil de courant de défaut admissible, et une unité de commande agencée pour, en cas de dépassement dudit seuil, déclencher une alarme.

### Technique antérieure :

Les dispositifs de contrôle et de surveillance de l'énergie alimentant une installation électrique sont bien connus et permettent la gestion de l'énergie, la détection et la sauvegarde des événements perturbateurs pour l'installation.

Les courants de défaut, appelés également courants résiduels, dans une installation électrique, correspondent à des défauts à la terre et à des défauts d'isolement. Ils sont mesurés à partir du courant différentiel. La surveillance des courants de défaut est basée sur la génération d'alarmes en cas de dépassement d'un seuil fixé par l'utilisateur. Cette fonction est appelée en langage international « Residual Current Monitoring » ou « RCM ».

Si le courant différentiel est nul ou quasi nul, l'installation électrique fonctionne correctement et les courants de défaut sont nuls ou quasi nuls. Néanmoins, il existe toujours une fuite de courant considérée comme naturelle, qui est due à la puissance de la charge, et dont la valeur est suffisamment faible pour être insignifiante. A l'inverse, si ce courant différentiel est différent de zéro et dépasse un seuil déterminé, une alarme est générée pour avertir l'utilisateur de l'apparition d'un défaut. Il peut ainsi surveiller son installation électrique, visualiser le défaut et intervenir sur son installation, sans nécessairement interrompre l'alimentation électrique.

La surveillance du courant différentiel permet de ne pas interrompre l'alimentation électrique dans des applications sensibles nécessitant une haute disponibilité, en prévenant les risques d'apparition de courants de défaut, comme par exemple dans les hôpitaux, les banques, les centres de traitement de données, certains processus industriels, etc. Cette surveillance facilite également la maintenance préventive sur des départs critiques comme des lignes de production, le contrôle de l'isolation des câbles, la prévention de la dégradation de la résistance d'isolation etc.

Il est donc important voire primordial d'assurer une surveillance permanente et précise du courant différentiel pour prévenir les défauts à la terre et les défauts d'isolement, réaliser un diagnostic précis de la localisation des défauts, éviter les campagnes périodiques de maintenance et assurer une haute disponibilité et grande fiabilité de l'installation électrique.

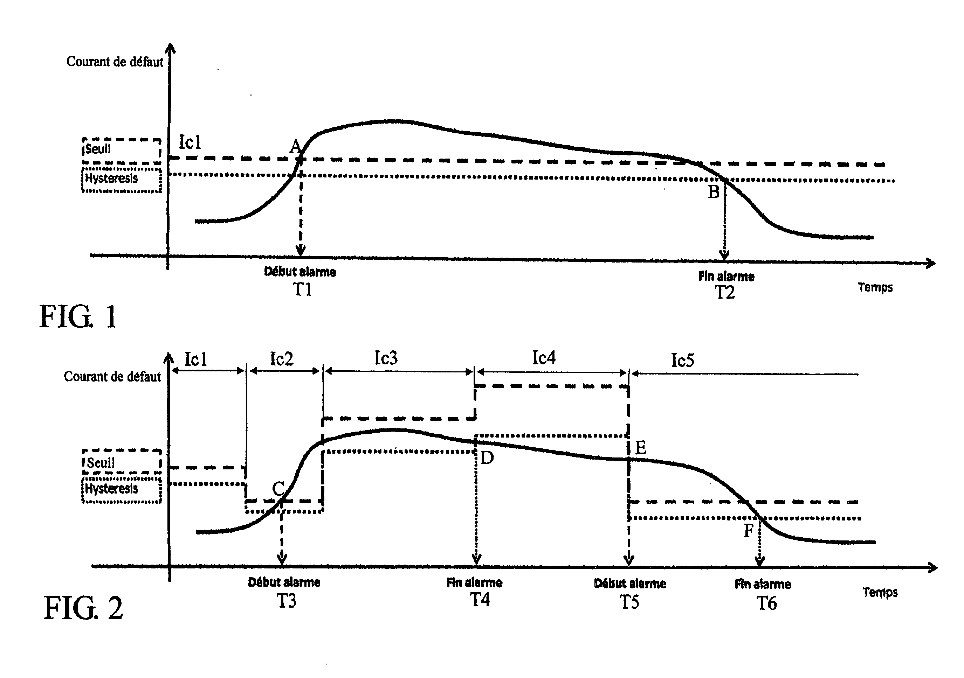

Le déclenchement des alarmes est effectué à l'heure actuelle à l'aide de seuils fixes généralement configurés par l'utilisateur. Le diagramme de la figure 1 illustre le procédé actuel de gestion des alarmes basé sur une configuration de seuil fixe. Le trait interrompu court représente le niveau de seuil qui a une valeur fixe et auquel est associée une hystérésis représentée en pointillés. La figure 1 montre le début et la fin d'un événement générant le déclenchement d'une alarme sur une courbe représentant le courant de défaut mesuré d'une installation en fonction du temps et ce quel que soit le courant de charge de ladite installation. Cette courbe n'est pas linéaire puisque le courant de défaut est notamment dépendant du courant de charge comme expliqué plus loin. Dès que la valeur mesurée du courant de défaut dépasse le seuil fixe (point A), l'alarme est activée à un instant T1. Et dès que la valeur mesurée du courant de défaut passe en-dessous de l'hystérésis (point B), l'alarme est arrêtée à un instant T2. Cette alarme est ensuite désactivée, si l'utilisateur effectue une action pour confirmer l'arrêt de l'alarme. L'hystérésis représente une marge négative de quelques pourcents de la valeur du seuil et empêche les déclenchements d'alarme intempestifs.

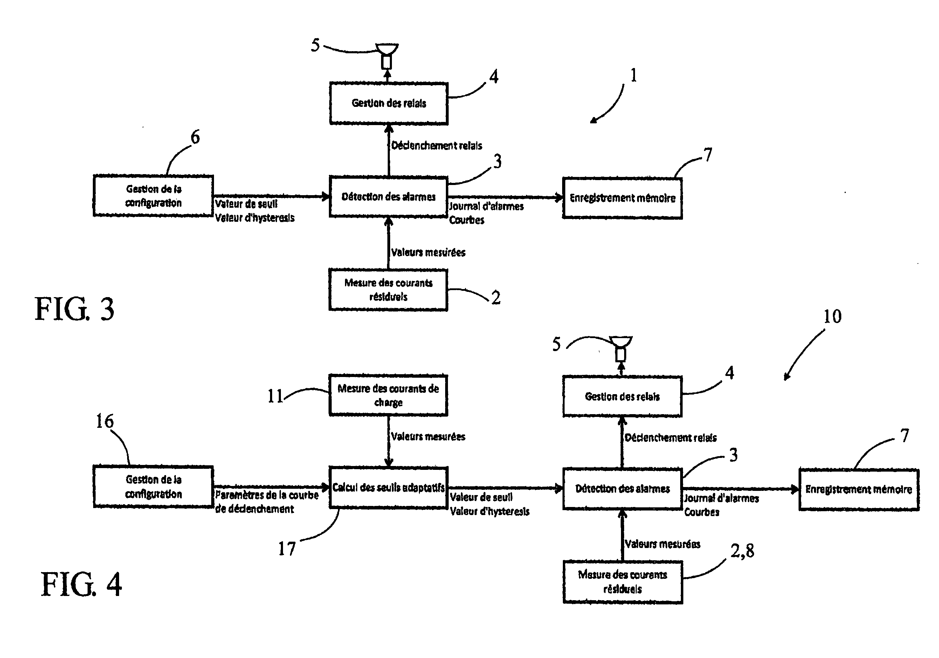

La mise en oeuvre du procédé actuel de gestion des alarmes est obtenue au moyen d'un dispositif de mesure 1 illustré par son schéma bloc à la figure 3. Il comporte un capteur de courant différentiel 2 agencé pour mesurer le courant différentiel IΔn de l'installation au moyen d'un tore différentiel disposé autour des conducteurs de phase et de neutre de l'installation. Sans courant de fuite, la somme vectorielle des courants est nulle (I1+I2+I3+In=0), c'est à dire que le courant différentiel est égal à zéro (IΔn=0) et il n'y pas de courant induit dans le tore différentiel. A l'inverse, si un courant de fuite existe, ce courant peut par exemple s'écouler à la terre à travers une résistance de fuite, la somme vectorielle des courants est différente de zéro (I1+I2+I3+In≠0) c'est à dire que le courant différentiel est différent de zéro (IΔn≠0) et analysé par un module de contrôle 3. Si le courant différentiel mesuré dépasse un seuil fixé par l'utilisateur alors le module de contrôle 3 enclenche une unité de commande 4 qui comporte au moins un relais d'alimentation d'une alarme 5 qui peut être visuelle et/ou sonore. L'alarme 5 peut aussi être transmise à une centrale de supervision délocalisée par un bus de communication ou tout autre moyen de communication adapté. Le module de contrôle 3 comporte une unité de paramétrage 6 constituant une interface homme/machine permettant à l'utilisateur d'entrer une valeur de seuil à partir de laquelle il souhaite déclencher l'alarme 5. Cette unité de paramétrage 6 comporte au moins un clavier et un écran pour communiquer avec l'utilisateur. Les évènements sont enregistrés dans une unité mémoire 7 qui peut être intégrée au dispositif de mesure 1 ou délocalisée dans une centrale de supervision via un bus de communication ou tout autre moyen équivalent.

Chaque appareil électrique de l'installation électrique constitue une charge et va naturellement générer un courant de fuite donc un courant de défaut. Le niveau de charge de l'installation est donc dépendant du nombre d'appareils électriques fonctionnant simultanément. L'augmentation du niveau de charge va donc naturellement accroître le courant de fuite donc le courant de défaut sans que l'installation électrique ne présente de réels disfonctionnements.

L'utilisateur va alors être confronté à la problématique suivante quant au choix de son seuil de déclenchement d'alarme :
→ Seuil réglé à une valeur faible : Ce réglage correspond à un fonctionnement de l'installation à un niveau de charge minimal. Il permet de détecter un maximum d'alarmes. Néanmoins, ce choix conduit à la génération d'alarmes intempestives et non pertinentes.
→ Seuil réglé à une valeur élevée : Ce réglage correspond à un fonctionnement de l'installation en pleine charge ou à un niveau de charge maximal. Il permet d'éviter des déclenchements intempestifs liés aux variations de charges dans l'installation. Néanmoins, des alarmes liées à un réel défaut risquent de ne pas être détectées.
→ La conséquence de l'un de ces choix est une analyse imprécise, peu fiable et difficilement exploitable de l'évolution des courants de défaut dans l'installation électrique.

Le procédé actuel de gestion des alarmes en fonction des courants de défaut, basé sur des seuils fixes, dans une installation électrique ne donne donc pas entière satisfaction.

D'autres procédés tentent d'intégrer une gestion dynamique des seuils d'alarme en fonction du courant de charge de l'installation électrique surveillée. La publication DE 102 51 001 B3 propose un procédé de détection de court-circuit dans une installation électrique par une mesure des courants de phases cumulés au moyen de transformateurs de courant et des tensions de phase de ladite installation, dans lequel on détecte une saturation éventuelle des transformateurs de courant et on règle la valeur des seuils de courant en fonction de la valeur maximale du courant de phase. La publication EP 0 407 310 A1 décrit un déclencheur statique pour un disjoncteur de protection d'un réseau électrique dans lequel le seuil de déclenchement différentiel est d'abord constant puis croît linéairement avec le courant de phase le plus élevé du réseau lorsque celui-ci dépasse une certaine valeur pour éviter des déclenchements intempestifs dus à de faux courants homopolaires. La publication US 6,546,342 B1 décrit un procédé de gestion des seuils d'alarme tenant compte de la somme des courants de phase, ces seuils d'alarme étant paramétrables. Et la publication DE 297 05 187 U1 décrit un disjoncteur différentiel tenant compte de deux seuils différents de courant de défaut, à savoir un premier seuil de courant de défaut différentiel et un second seuil de courant de défaut à la terre, ces seuils de courant étant fixes et non variables en fonction de la charge.

Toutefois, aucun procédé connu pour la gestion des alarmes dans une installation électrique ne permet un diagnostic précis de la localisation des défauts détectés dans ladite installation.

### Exposé de l'invention :

La présente invention vise à apporter une solution aux problèmes évoqués ci-dessus en proposant un procédé de gestion des alarmes optimisé, dynamique, précis, fiable et évolutif, permettant le déclenchement d'alarmes pertinentes en fonction des courants de défaut détectés et selon le niveau de charge effectif de l'installation électrique, ce procédé apportant une aide précieuse dans l'analyse du type de défaut détecté et dans la caractérisation de son origine, permettant d'assurer ainsi une maintenance préventive de qualité et de garantir une grande fiabilité et une haute disponibilité des installations électriques surveillées.

Dans ce but, l'invention concerne un procédé du genre indiqué en préambule, caractérisé en ce que l'on détermine pour chaque courant de défaut mesuré au moins deux seuils différents de courant de défaut admissibles et adaptés à au moins deux valeurs différentes du courant de charge de ladite installation, l'on mesure en permanence le courant de charge instantané de ladite installation, et l'on déclenche ladite alarme si l'un des courants de défaut mesurés est supérieur au seuil de courant de défaut admissible et adapté à ladite valeur du courant de charge mesurée.

De manière préférentielle, l'on détermine plusieurs seuils différents de courant de défaut admissibles et adaptés à plusieurs valeurs différentes du courant de charge de ladite installation.

L'on détermine avantageusement lesdits seuils différents de courant de défaut en fonction desdites valeurs différentes du courant de charge de ladite installation sous la forme d'une courbe de détection.

Pour déterminer ladite courbe de détection, l'on peut définir au moins deux points différents de ladite courbe, chaque point étant défini en abscisse par une valeur choisie du courant de charge de ladite installation et en ordonnée par un seuil de courant de défaut admissible pour ladite valeur choisie du courant de charge. Pour déterminer un premier point de ladite courbe de détection, l'on peut choisir une valeur minimale du courant de charge de ladite installation et, pour déterminer un second point de ladite courbe de détection, l'on peut choisir une valeur maximale du courant de charge de ladite installation.

De manière préférentielle, pour déterminer ladite courbe de détection, l'on définit n points de ladite courbe pour n valeurs différentes du courant de charge de ladite installation, n pouvant être égal à six par exemple.

Selon un premier procédé, l'on peut déterminer les points de ladite courbe de détection manuellement et, dans ce cas, l'on définit et l'on enregistre un seuil de courant de défaut admissible pour différentes valeurs théoriques du courant de charge de ladite installation.

Selon un second procédé, l'on peut déterminer les points de ladite courbe de détection automatiquement et, dans ce cas, l'on mesure le courant de charge pour différents niveaux de charge de ladite installation, l'on mesure le courant de défaut nominal correspondant à chaque niveau de charge de ladite installation, l'on ajoute au courant de défaut nominal mesuré une valeur d'écart pour définir le seuil de courant de défaut admissible et l'on enregistre ledit seuil de courant de défaut admissible obtenu pour lesdits niveaux de charge différents de ladite installation.

L'on peut aussi attribuer à chaque seuil de courant de défaut admissible déterminé une valeur d'hystérésis, qui est inférieure audit seuil. De fait, dès que le courant de défaut mesuré passe en dessous de la valeur d'hystérésis correspondante audit seuil, l'on peut arrêter l'alarme préalablement déclenchée.

Dans ce but également, l'invention concerne un dispositif du genre indiqué en préambule, caractérisé en ce qu'il comporte une unité de paramétrage agencée pour déterminer, pour chaque courant de défaut mesuré, au moins deux seuils de courant de défaut différents et adaptés à au moins deux valeurs différentes du courant de charge de ladite installation, un module de calcul communicant d'une part avec ladite unité de paramétrage et d'autre part avec ledit module de contrôle, et un appareil de mesure du courant de charge instantané de ladite installation communicant avec ledit module de calcul.

L'unité de paramétrage comporte avantageusement au moins un écran et un clavier pour communiquer avec un utilisateur et lui permettre d'enregistrer au moins deux seuils différents de courant de défaut admissibles en fonction de deux valeurs différentes du courant de charge de ladite installation. Le dispositif de l'invention peut comporter en outre un bus de communication agencé pour communiquer avec une centrale de surveillance délocalisée.

### Description sommaire des dessins :

La présente invention et ses avantages apparaîtront mieux dans la description suivante d'un mode de réalisation donné à titre d'exemple non limitatif, en référence aux dessins annexés, dans lesquels:
- la figure 1 est un diagramme illustrant le procédé de gestion des alarmes en fonction des courants de défaut basé sur un seuil fixe conformément à l'art antérieur,
- la figure 2 est un diagramme illustrant le procédé de gestion des alarmes en fonction des courants de défaut basé sur des seuils dynamiques conformément à l'invention,
- la figure 3 est un schéma bloc du dispositif de mesure de l'art antérieur,
- la figure 4 est un schéma bloc du dispositif de mesure selon l'invention,
- la figure 5 est un diagramme représentant deux courbes de seuils dynamiques respectivement de courant différentiel et de courant de fuite à la terre, chaque courbe de seuils étant associée à une courbe d'hystérésis, les valeurs indiquées n'étant données qu'à titre d'exemple, et
- la figure 6 est un schéma du dispositif de mesure selon l'invention monté en amont d'une installation électrique.

### Illustrations de l'invention et meilleure manière de réaliser l'invention :

Comme décrit précédemment, tout appareil électrique produit une fuite de courant ou courant de défaut aussi appelé courant résiduel. De plus, chaque appareil électrique est considéré comme une charge dans l'installation électrique, cette charge étant représentée et symbolisée par un courant de charge Ic. Le courant de défaut induit par les charges d'une installation est normal et ne doit pas être traité comme un défaut susceptible de déclencher une alarme. Ce courant de défaut correspond à un défaut d'isolement engendrant un courant de fuite à la terre, et est mesuré à partir du courant différentiel de l'installation.

Le procédé de gestion selon l'invention se distingue du procédé de l'art antérieur en ce que le seuil de détection d'alarme n'est plus figé comme dans l'exemple de la figure 1 mais est adapté en temps réel à la charge effective et instantanée de l'installation électrique. Ainsi, le courant de charge Ic est utilisé comme paramètre pour déterminer le seuil de détection d'alarme. Si le courant de défaut augmente en même temps que le courant de charge Ic, alors il ne s'agit pas d'un réel défaut et il n'y a pas lieu de générer une alarme. Si le courant de défaut augmente sans augmentation du courant de charge Ic, alors il s'agit d'un vrai défaut et une alarme doit être générée.

Par cette approche, le procédé de gestion selon l'invention permet d'adapter en temps réel le seuil d'alarme au nombre d'appareils électriques connectés à l'installation électrique à un instant T et donc au courant de défaut naturel induit par ces appareils. Les vrais défauts sont détectés et génèrent une alarme et les faux défauts sont ignorés.

Le diagramme de la figure 2 permet d'illustrer ce procédé de gestion des alarmes basé sur une configuration de seuils variables et adaptés aux niveaux de charge représentatifs de l'installation électrique. Pour faciliter la compréhension du procédé selon l'invention au regard du procédé de l'art antérieur, la courbe représentant le courant de défaut mesuré de la figure 2 est la même que celle de la figure 1. Le trait interrompu court représente cinq niveaux de seuils déterminés pour cinq niveaux de charge possibles de l'installation identifiés par Ic1, Ic2, Ic3, Ic4 et Ic5. A chaque niveau de seuil correspond une hystérésis représentée en pointillés.

Le diagramme de la figure 2 montre le début et la fin de deux évènements qui ont donné lieu à un déclenchement d'alarme sur la courbe représentant le courant de défaut mesuré de l'installation en fonction du temps et en tenant compte également du courant de charge de cette installation, à l'inverse de la figure 1 où seul un événement a été détecté. La valeur mesurée du courant de défaut dépasse un niveau de seuil déterminé pour un courant de charge Ic2 donné (point C) à un instant T3, qui se situe plus tôt que l'instant T2 de la figure 1. Une première alarme est activée. La valeur mesurée du courant de défaut passe en-dessous de l'hystérésis (point D) à un instant T4 non détecté à la figure 1. L'alarme est arrêtée. On constate qu'entre les instants T3 et T4, le courant de charge de l'installation a augmenté et est passé de Ic2 à Ic3 avec comme incidence une augmentation du niveau du seuil de déclenchement d'alarme. C'est pourquoi le point D, qui correspond à un courant de défaut en légère baisse, mais à un courant de charge en hausse, va déclencher l'arrêt de l'alarme qui n'est plus justifiée. Avec un seuil fixe déterminé sur un niveau de courant de charge Ic1, comme dans la figure 1, le point D n'a eu aucun effet et l'alarme a été maintenue active sans raison.

Le diagramme de la figure 2 montre un deuxième événement au cours duquel la valeur mesurée du courant de défaut dépasse un autre niveau de seuil déterminé pour un courant de charge Ic5 donné (point E) à un instant T5 non détecté à la figure 1. Une seconde alarme est activée. La valeur mesurée du courant de défaut passe en-dessous de l'hystérésis (point F) à un instant T6 qui se situe après l'instant T2 de la figure 1. L'alarme est arrêtée. Là encore, on constate qu'entre les instants T4 et T5, le courant de charge de l'installation a augmenté et est passé de Ic3 à Ic4 avec comme incidence une augmentation du niveau du seuil de déclenchement d'alarme. Néanmoins, le courant de défaut mesuré est considéré comme normal et ne déclenche pas d'alarme. Par contre, entre les instants T5 et T6, le courant de charge de l'installation a diminué fortement et est passé de Ic4 à Ic5 avec comme incidence une diminution brutale du niveau du seuil de déclenchement d'alarme, détectant au point E un courant de défaut supérieur au niveau du seuil à l'instant T5. Avec un seuil fixe déterminé sur un niveau de courant de charge Ic1, comme dans la figure 1, l'alarme est restée active depuis l'instant T1. Par ailleurs, le point B de la figure 1 commande l'arrêt de l'alarme à un instant T2 alors que le courant de défaut mesuré est encore au-dessus du niveau du seuil correspondant à un courant de charge Ic5. Dans tous les cas et à la fin d'une alarme, comme dans le procédé de l'art antérieur, l'utilisateur doit effectuer une action pour confirmer l'arrêt de l'alarme.

Cette illustration montre la pertinence du procédé de gestion selon l'invention et le niveau de précision qu'il permet d'atteindre grâce à un seuil de détection dynamique et adapté au niveau de charge de l'installation électrique.

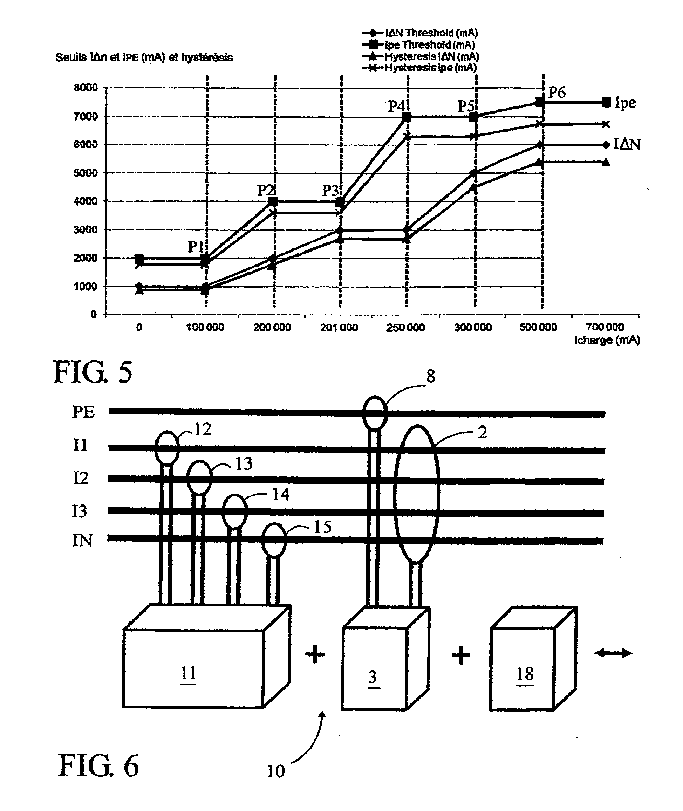

En référence aux figures 4 et 6, le dispositif de mesure 10 selon l'invention permettant de mettre en oeuvre ce procédé de gestion des alarmes basé sur des seuils adaptatifs comporte le dispositif de mesure 1 de l'art antérieur représenté à la figure 3 dont les composants sont identifiés avec les mêmes numéros de référence. Il comporte en outre un appareil de mesure 11 agencé pour mesurer le courant de charge Ic instantané de l'installation électrique, un module de calcul 17 qui reçoit les données de l'appareil de mesure 11, une unité de paramétrage 16 différente de celle de la figure 3 et un bus de communication 18 ou similaire (cf. fig. 6) pour communiquer par exemple avec une centrale de supervision (non représentée). Le dispositif de mesure 10 comporte d'une part un capteur de courant différentiel 2 agencé pour mesurer le courant différentiel IΔn de l'installation au moyen d'un tore différentiel disposé autour des conducteurs I1, I2, I3 et In et d'autre part un capteur de courant de fuite à la terre 8 agencé pour mesurer le courant de fuite à la terre Ipe de l'installation au moyen d'un tore disposé autour du conducteur de mise à la terre PE de l'installation (cf. fig. 6). Comme la valeur mesurée du courant différentiel IΔn, la valeur mesurée du courant de fuite à la terre Ipe est analysée par le module de contrôle 3. Cette valeur permet de générer également une alarme sur des seuils adaptatifs paramétrés par l'utilisateur dans l'unité de paramétrage 16.

L'appareil de mesure 11 comporte un capteur de courant par conducteur de l'installation, à savoir dans l'exemple représenté quatre capteurs de courant 12, 13, 14, 15 mesurant respectivement le courant I1, I2, I3 dans les trois conducteurs de phase et le courant In dans le conducteur de neutre. Cet appareil de mesure 11 peut être interne au dispositif de mesure 10 ou externe et lié au dispositif de mesure 10 au travers d'un bus de communication ou tout autre moyen de communication équivalent.

Cet appareil de mesure 11 communique avec le module de calcul 17 qui va calculer le courant de charge Ic de l'installation électrique en faisant la moyenne des courants de charge Ic=(I1+I2+I3)/3 pour un réseau triphasé ou quadriphasé, ou en prenant simplement la valeur du courant de charge Ic=I1 pour un réseau monophasé.

Comme expliqué en référence à la figure 3, la mesure des courants de défaut s'effectue au travers d'un capteur de courant différentiel 2 mesurant le courant différentiel IΔn, complété d'un capteur de courant de fuite à la terre 8 mesurant le courant de fuite à la terre Ipe. Ces deux mesures de courant de défaut sont réalisées en permanence et simultanément par deux capteurs différents. Elles sont de préférence amplifiées pour atteindre une précision maximale sur une plage de mesure étendue qui s'étend par exemple de 5mA à 30A.

L'unité de paramétrage 16 du dispositif de mesure 10 selon l'invention est perfectionnée par rapport à celle décrite en référence au dispositif de mesure 1 de la figure 3. En effet, elle permet à l'utilisateur de modéliser son installation électrique et ses courants de défaut sous la forme d'une première courbe de détection des seuils d'alarme en fonction du courant différentiel IΔn de l'installation. Cette première courbe est déterminée par n points, par exemple entre deux et six points, chaque point étant défini en abscisse par un courant de charge Ic et en ordonnée par un courant différentiel IΔn correspondant. L'utilisateur effectue la même démarche pour déterminer une seconde courbe de détection des seuils d'alarme en fonction du courant de fuite à la terre Ipe de l'installation. Cette seconde courbe est déterminée par n points, par exemple entre deux et six points, chaque point étant défini en abscisse par un courant de charge Ic et en ordonnée par un courant de fuite à la terre Ipe correspondant. Ces courbes de détection sont illustrées dans le diagramme de la figure 5.

Pour chaque courbe de détection du courant différentiel IΔn ou du courant de fuite à la terre Ipe de l'installation, chaque point P1, P2, P3, P4, P5, P6 (pour un nombre de points n égal à six) correspond un seuil de courant différentiel IΔn ou de courant de fuite à la terre Ipe admissible pour un courant de charge Ic de l'installation au-delà duquel une alarme sera déclenchée. Le nombre de points est choisi par exemple entre deux et six de façon à modéliser le plus précisément possible l'installation. Bien entendu, ce nombre de points n'est pas limité à six et peut comporter un nombre de points supérieur à six. Toutefois, au moins deux points sont nécessaires pour définir une courbe. Le premier point P1 de la courbe représente typiquement l'installation électrique avec un niveau de charge minimal et le dernier point P6 de la courbe représente un niveau de charge maximal. Pour assurer une continuité dans la détection d'alarme quelle que soit le niveau de charge de l'installation, deux points successifs de la courbe de détection sont réunis par un segment de droite.

Les courbes de détection sont définies par l'utilisateur en fonction de son installation électrique. Ces courbes de détection sont linéaires par morceaux. Elles peuvent comporter un nombre quelconque de points et au moins deux points. Les valeurs du seuil de détection sont calculées dans le module de calcul 17 à partir des valeurs du courant de charge Ic de l'installation.

L'utilisateur dispose de deux possibilités pour configurer ses courbes de détection : un mode manuel ou un mode automatique.

L'utilisateur peut configurer manuellement les points de la courbe de détection en définissant les coordonnées de chacun des points P1 à P6. Il dispose pour cela d'un écran et d'un clavier, ou d'un écran tactile, dans l'unité de paramétrage 16, qui lui permettent d'entrer en abscisse le courant de charge Ic de l'installation dans différentes configurations de charge, et en ordonnée le seuil de détection qu'il souhaite pour chacune des configurations de charge qu'il a identifiées. Ces points P1 à P6 représentent l'installation lorsque les charges sont activées ou non. Ces points peuvent être également définis par l'utilisateur au niveau d'une centrale de supervision puis envoyés à l'unité de paramétrage 16 par un bus de communication 18 ou tout autre moyen de communication équivalent.

Si l'utilisateur choisit le mode automatique, le dispositif de mesure 10 selon l'invention va mesurer d'une part le courant différentiel IΔn nominal et d'autre part le courant de fuite à la terre Ipe nominal en fonction du courant de charge de l'installation électrique dans différentes configurations de charge. C'est pourquoi, au cours du processus automatique, l'utilisateur modifie le niveau de charge de son installation électrique sur une plage très large afin de créer d'une part la courbe du courant différentiel IΔn nominal et d'autre part la courbe du courant de fuite à la terre Ipe en fonction du courant de charge représentatif de son installation. Puis l'utilisateur ou le dispositif ajoute une valeur d'écart (offset) sur les valeurs mesurées du courant différentiel IΔn nominal et du courant de fuite à la terre Ipe pour définir les différents niveaux de seuil admissible. Cette valeur d'offset représente la différence entre le niveau de courant de défaut IΔn, Ipe nominal et le niveau de courant de défaut IΔn, Ipe devant générer une alarme.

A partir de la mesure des courants de défaut différentiels IΔn et de fuite à la terre Ipe et des courbes de seuils de détection dynamiques des alarmes selon la figure 5, le dispositif de mesure 10 est capable de détecter les alarmes, comme décrit en référence au diagramme de la figure 2.

La mesure simultanée des deux courants de défaut IΔn et Ipe permet de comparer leurs valeurs lors d'un déclenchement sur l'un ou l'autre de ces courants de défaut afin d'apporter une aide dans l'analyse du type de défaut et dans la caractérisation de son origine. Par exemple, si le déclenchement d'une alarme se produit sur une élévation du courant de défaut différentiel IΔn et que la valeur du courant de fuite à la terre Ipe reste faible, alors le courant de défaut ne s'écoule pas à la terre PE mais par un autre chemin dans l'installation électrique. Ce diagnostic, difficilement possible avec les dispositifs de détection connus, permet alors d'effectuer une recherche de fuite plus approfondie dans le cadre d'une opération de maintenance de ladite installation électrique.

Lorsqu'une alarme est détectée, le dispositif de mesure 10 peut générer les actions suivantes :
- enregistrement de l'alarme avec horodatation dans un journal d'évènements,
- enregistrement des mesures sous la forme d'une courbe pour une analyse ultérieure,
- basculement de l'état d'un relais pour une signalisation extérieure,
- transmission des alarmes, des mesures et des courbes par le bus de communication 18 ou similaire à une centrale de supervision.

Le dispositif de mesure 10 selon l'invention peut permettre d'intégrer des paramètres supplémentaires dans la configuration des courbes de détection d'alarme, telle que par exemple une temporisation de la détection pour un filtrage des variations transitoires des courants de défaut et éviter notamment des déclenchements d'alarme intempestifs comme par exemple au démarrage d'un moteur.

Le dispositif de mesure 10 peut s'appliquer à la surveillance des courants de défaut pour des applications de monitoring, comme expliqué ci-dessus, mais également pour des applications de protection engendrant une coupure à l'alimentation électrique de l'installation.

### Possibilités d'application industrielle :

Il ressort clairement de cette description que l'invention permet d'atteindre les buts fixés, à savoir un procédé de gestion des alarmes et un dispositif de mesure mettant en oeuvre ce procédé capable de surveiller tout type d'installation électrique, existante ou nouvelle, avec une grande précision, une justesse non égalée à ce jour et un diagnostic précis du type de défaut et de son origine permettant une maintenance préventive optimisée.

La présente invention n'est pas limitée à l'exemple de réalisation décrit mais s'étend à toute modification et variante évidentes pour un homme du métier tout en restant dans l'étendue de la protection définie dans les revendications annexées.

## Revendications

1. Procédé de gestion des alarmes en fonction des courants de défaut dans une installation électrique, dans lequel on mesure en permanence le courant de défaut différentiel (IΔn) de ladite installation électrique par un capteur de courant différentiel (2) et le courant de défaut à la terre (Ipe) de ladite installation électrique par un capteur de courant de fuite à la terre (8), on compare chaque courant de défaut mesuré à un seuil de courant de défaut admissible et, en cas de dépassement dudit seuil, on déclenche une alarme (5), procédé **caractérisé en ce que** l'on détermine pour chaque courant de défaut (IΔn, Ipe) mesuré au moins deux seuils différents de courant de défaut admissibles et adaptés à au moins deux valeurs différentes du courant de charge de ladite installation, l'on mesure en permanence le courant de charge instantané de ladite installation, et l'on déclenche ladite alarme si l'un des courants de défaut mesurés est supérieur au seuil de courant de défaut admissible et adapté à ladite valeur du courant de charge mesurée.

2. Procédé selon la revendication 1, **caractérisé en ce que** l'on détermine plusieurs seuils différents de courant de défaut admissibles et adaptés à plusieurs valeurs différentes du courant de charge de ladite installation.

3. Procédé selon la revendication 2, **caractérisé en ce que** l'on détermine lesdits seuils différents de courant de défaut en fonction desdites valeurs différentes du courant de charge de ladite installation sous la forme d'une courbe de détection.

4. Procédé selon la revendication 3, **caractérisé en ce que**, pour déterminer ladite courbe de détection, l'on définit au moins deux points différents de ladite courbe, chaque point étant défini en abscisse par une valeur choisie du courant de charge de ladite installation et en ordonnée par un seuil de courant de défaut admissible pour ladite valeur choisie du courant de charge.

5. Procédé selon la revendication 4, **caractérisé en ce que**, pour déterminer un premier point de ladite courbe de détection, l'on choisit pour une valeur minimale du courant de charge de ladite installation et, pour déterminer un second point de ladite courbe de détection, l'on choisit une valeur maximale du courant de charge de ladite installation.

6. Procédé selon la revendication 4, **caractérisé en ce que**, pour déterminer ladite courbe de détection, l'on définit n points de ladite courbe pour n valeurs différentes du courant de charge de ladite installation.

7. Procédé selon la revendication 6, **caractérisé en ce que** l'on définit six points de ladite courbe pour six valeurs différentes du courant de charge de ladite installation.

8. Procédé selon l'une quelconque des revendications 4 à 7, **caractérisé en ce que** l'on détermine manuellement les points de ladite courbe de détection et **en ce que** l'on définit et enregistre un seuil de courant de défaut admissible pour différentes valeurs théoriques du courant de charge de ladite installation.

9. Procédé selon l'une quelconque des revendications 4 à 7, **caractérisé en ce que** l'on détermine automatiquement les points de ladite courbe de détection et **en ce que** l'on mesure le courant de charge pour différents niveaux de charge de ladite installation, l'on mesure le courant de défaut nominal correspondant à chaque niveau de charge de ladite installation, l'on ajoute au courant de défaut nominal mesuré une valeur d'écart pour définir le seuil de courant de défaut admissible et l'on enregistre ledit seuil de courant de défaut admissible obtenu pour lesdits niveaux de charge différents de ladite installation.

10. Procédé selon l'une quelconque des revendications précédentes, **caractérisé en ce que** l'on attribue à chaque seuil de courant de défaut admissible déterminé une valeur d'hystérésis, qui est inférieure audit seuil, et **en ce que**, dès que le courant de défaut mesuré passe en dessous de la valeur d'hystérésis correspondante audit seuil, l'on arrête l'alarme préalablement déclenchée.

11. Dispositif (10) de mise en oeuvre du procédé de gestion des alarmes en fonction des courants de défaut dans une installation électrique selon l'une quelconque des revendications précédentes, dispositif comportant un capteur de courant différentiel (2) agencé pour mesurer en permanence le courant de défaut différentiel (IΔn) de ladite installation, un capteur de courant de fuite à la terre (8) agencé pour mesurer en permanence le courant de défaut à la terre (Ipe) de ladite installation, un module de contrôle (3) agencé pour comparer chaque courant de défaut mesuré à un seuil de courant de défaut admissible, et une unité de commande (4) d'une alarme (5) agencée pour, en cas de dépassement dudit seuil, déclencher une alarme, dispositif **caractérisé en ce qu'**il comporte en outre une unité de paramétrage (16) agencée pour déterminer, pour chaque courant de défaut (IΔn, Ipe) mesuré, au moins deux seuils de courant de défaut différents et adaptés à au moins deux valeurs différentes du courant de charge de ladite installation, un module de calcul (17) communicant d'une part avec ladite unité de paramétrage (16) et d'autre part avec ledit module de contrôle (3), et un appareil de mesure (11) du courant de charge instantané de ladite installation communicant avec ledit module de calcul (17).

12. Dispositif selon la revendication 11, **caractérisé en ce que** ledit appareil de mesure (11) comporte un capteur de courant sur chaque conducteur de l'installation électrique pour mesurer le courant dans chacun desdits conducteurs, et communique avec ledit module de calcul (17) agencé pour faire la moyenne des courants mesurés sur lesdits conducteurs et déterminer ledit courant de charge de l'installation

13. Dispositif selon la revendication 11, **caractérisé en ce que** lesdits capteurs de courant de défaut (2, 8) sont couplés à des amplificateurs pour atteindre une précision maximale sur une plage de mesure étendue qui s'étend de 5mA à 30A.

14. Dispositif selon la revendication 11, **caractérisé en ce que** ladite unité de paramétrage (16) comporte au moins un écran et un clavier pour communiquer avec un utilisateur et lui permettre d'enregistrer au moins deux seuils différents de courant de défaut admissibles en fonction de deux valeurs différentes du courant de charge de ladite installation.

15. Dispositif selon la revendication 11, **caractérisé en ce qu'**il comporte en outre un bus de communication (18) agencé pour communiquer avec une centrale de surveillance délocalisée.

## Patentansprüche

1. Verfahren zur Verwaltung von Alarmsignalen in Abhängigkeit von den Fehlerströmen in einer elektrischen Anlage, bei dem man ständig den Differenz-Fehlerstrom (IΔn) von besagter elektrischen Anlage mittels eines Differenzstromsensors (2) und den Erdfehlerstrom (Ipe) von besagter elektrischen Anlage mittels eines Erdstromsensors (8) misst, man jeden gemessenen Fehlerstrom mit einer zulässigen Fehlerstromschwelle vergleicht und man, bei Überschreitung der besagten Schwelle, einen Alarm (5) auslöst, **dadurch gekennzeichnete**s Verfahren, dass man für jeden gemessenen Fehlerstrom (IΔn, Ipe) zumindest zwei unterschiedliche, für zumindest zwei unterschiedliche Laststromwerte der besagten Anlage geeignete zulässige Fehlerstromschwellen festlegt, man ständig den momentanen Laststrom von besagter Anlage misst, und man besagten Alarm auslöst, wenn einer der gemessenen Fehlerströme die zulässige und für den besagten gemessenen Laststromwert geeignete Fehlerstromschwelle überschreitet.

2. Verfahren nach Anspruch 1, **dadurch gekennzeichnet, dass** man mehrere unterschiedliche, für mehrere unterschiedliche Laststromwerte der besagten Anlage geeignete, zulässige Fehlerstromschwellen festlegt.

3. Verfahren nach Anspruch 2, **dadurch gekennzeichnet, dass** man besagte unterschiedliche Fehlerstromschwellen je nach den besagten unterschiedlichen Laststromwerten von besagter Anlage in der Form einer Erfassungskurve festlegt.

4. Verfahren nach Anspruch 3, **dadurch gekennzeichnet, dass**, um besagte Erfassungskurve zu bestimmen, man zumindest zwei unterschiedliche Punkte von besagter Kurve festlegt, wobei die Abzisse jedes Punkts einen gewählten Laststromwert der besagten Anlage und die Ordinate eine für besagten gewählten Laststromwert zulässige Fehlerstromschwelle darstellt.

5. Verfahren nach Anspruch 4, **dadurch gekennzeichnet, dass**, um einen ersten Punkt von besagter Erfassungskurve festzulegen, man einen Mindest-Laststromwert von besagter Anlage wählt und, um einen zweiten Punkt von besagter Erfassungskurve festzulegen, man einen Höchst-Laststromwert von besagter Anlage wählt.

6. Verfahren nach Anspruch 4, **dadurch gekennzeichnet, dass**, um besagte Erfassungskurve zu bestimmen, man n Punkte von besagter Kurve für n unterschiedliche Laststromwerte von besagter Anlage festlegt.

7. Verfahren nach Anspruch 6, **dadurch gekennzeichnet, dass** man sechs Punkte von besagter Kurve für sechs unterschiedliche Laststromwerte von besagter Anlage festlegt.

8. Verfahren nach einem beliebigen der Ansprüche 4 bis 7, **dadurch gekennzeichnet, dass** man die Punkte von besagter Erfassungskurve manuell festlegt, und dass man für unterschiedliche theoretische Laststromwerte von besagter Anlage eine zulässige Fehlerstromschwelle festlegt und abspeichert.

9. Verfahren nach einem beliebigen der Ansprüche 4 bis 7, **dadurch gekennzeichnet, dass** man die Punkte von besagter Erfassungskurve automatisch festlegt und dass man den Laststrom für unterschiedliche Lastpegel von besagter Anlage misst, man den jedem Lastpegel von besagter Anlage entsprechenden Nenn-Fehlerstrom misst, man zu dem gemessenen Nenn-Fehlerstrom einen Abweichungswert addiert, um die zulässige Fehlerstromschwelle zu bestimmen, und man besagte für die unterschiedlichen Lastpegel von besagter Anlage erhaltene zulässige Fehlerstromschwelle abspeichert.

10. Verfahren nach einem beliebigen der vorhergehenden Ansprüche, **dadurch gekennzeichnet, dass** man jeder festgelegten zulässigen Fehlerstromschwelle einen Hysterese-Wert zuteilt, der niedriger als besagte Schwelle ist, und dadurch, dass, sobald der gemessene Fehlerstrom die besagter Schwelle entsprechende Hysterese unterschreitet, man den vorher ausgelösten Alarm ausschaltet.

11. Vorrichtung (10) zur Umsetzung des Verfahrens zur Verwaltung von Alarmsignalen in Abhängigkeit von den Fehlerströmen in einer elektrischen Anlage nach einem beliebigen der vorhergehenden Ansprüche, wobei diese Vorrichtung einen Differenzstromsensor (2) beträgt, der ausgelegt ist, um ständig den Differenz-Fehlerstrom (IΔn) von besagter Anlage zu messen, sowie einen Erdstromsensor (8), der ausgelegt ist, um ständig den Erdfehlerstrom (Ipe) von besagter Anlage zu messen, ein Kontrollmodul (3), das ausgelegt ist, um jeden gemessenen Fehlerstrom mit einer zulässigen Fehlerstromschwelle zu vergleichen, und eine Steuereinheit (4) eines Alarms (5), die ausgelegt ist, um bei Überschreitung von besagter Schwelle einen Alarm auszulösen, **dadurch gekennzeichnete** Vorrichtung, dass sie außerdem eine Parametriereinheit (16) aufweist, die ausgelegt ist, um für jeden gemessenen Fehlerstrom (IΔn, Ipe) zumindest zwei unterschiedliche, für zumindest zwei unterschiedliche Laststromwerte von besagter Anlage geeignete zulässige Fehlerstromschwellen festzulegen, sowie ein einerseits mit besagter Parametriereinheit (16) und andererseits mit besagtem Kontrollmodul (3) in Verbindung stehendes Rechenmodul (17), und ein mit besagtem Rechenmodul (17) in Verbindung stehendes Messgerät (11) für den momentanen Laststrom der besagten Anlage.

12. Vorrichtung nach Anspruch 11, **dadurch gekennzeichnet, dass** besagtes Messgerät (11) auf jedem Leiter der elektrischen Anlage einen Stromsensor beträgt, um den Strom in jedem der besagten Leiter zu messen, und mit besagtem Rechenmodul (17), das ausgelegt ist, um den Durchschnittswert der auf besagten Leitern gemessen Ströme zu errechnen und besagten Laststrom der Anlage zu bestimmen, in Verbindung steht.

13. Vorrichtung nach Anspruch 11, **dadurch gekennzeichnet, dass** besagte Fehlerstromsensoren (2, 8) mit Verstärkern gekoppelt sind, um in einem breiten Messbereich, der sich vom 5mA bis 30A erstreckt, eine maximale Genauigkeit zu erreichen.

14. Vorrichtung nach Anspruch 11, **dadurch gekennzeichnet, dass** besagte Parametriereinheit (16) zumindest einen Bildschirm und eine Tastatur beträgt, um mit einem Benutzer zu kommunizieren und diesem zu erlauben, zumindest zwei unterschiedliche zulässige Fehlerstromschwellen für zwei unterschiedliche Laststromwerte von besagter Anlage abzuspeichern.

15. Vorrichtung nach Anspruch 11, **dadurch gekennzeichnet, dass** sie außerdem einen Kommunikationsbus (18) beträgt, der ausgelegt ist, um mit einer entfernten Überwachungszentrale zu kommunizieren.

## Claims

1. Method for managing alarms in accordance with fault currents in an electrical facility, wherein one measures permanently the differential fault current (IΔn) of said electrical facility with a differential current sensor (2) and the earth fault current (Ipe) of said electrical facility with an earth leakage current sensor (8), one compares each measured fault current with a permissible fault current threshold and, when said threshold is exceeded, one triggers an alarm (5), method **characterized in that** one determines for every measured fault current (IΔn, Ipe) at least two different permissible fault current thresholds that are adapted to at least two different load current values of said facility, one measures permanently the instantaneous load current of said facility, and one triggers said alarm if one of the measured fault currents exceeds the permissible fault current threshold that is adapted for said measured load current value.

2. Method according to claim 1, **characterized in that** one defines several different permissible fault current thresholds adapted to several different load current values of said facility.

3. Method according to claim 2, **characterized in that** one defines said different fault current thresholds in function of said different load current values of said facility in the form of a detection curve.

4. Method according to claim 3, **characterized in that**, in order to define said detection curve, one defines at least two different points of said curve, each point being defined in abscissa direction by a chosen load current value of said facility and in ordinate direction by a permissible fault current threshold for said chosen load current value.

5. Method according to claim 4, **characterized in that**, in order to determine a first point of said detection curve, one chooses a minimum load current value of said facility and, to determine a second point of said detection curve, one chooses a maximum load current value of said facility.

6. Method according to claim 4, **characterized in that**, in order to define said detection curve, one defines n points of said curve for n different load current values of said facility.

7. Method according to claim 6, **characterized in that** one defines six points of said curve for six different load current values of said facility.

8. Method according to any of claims 4 to 7, **characterized in that** one determines manually the points of said detection curve and **in that** one defines and stores a permissible fault current threshold for different theoretical load current values of said facility.

9. Method according to any of claims 4 to 7, **characterized in that** one determines automatically the points of said detection curve and **in that** one measures the load current for different load levels of said facility, one measures the nominal fault current corresponding to each load level of said facility, one adds an offset value to the measured nominal fault current to define the permissible fault current threshold and one stores said permissible fault current threshold obtained for said different load levels of said facility.

10. Method according to any of the previous claims, **characterized in that** one assigns to every permissible fault current threshold determined a hysteresis value that is lower than said threshold, and **in that**, as soon as the measured fault current becomes lower than the hysteresis value corresponding to said threshold, one stops the previously triggered alarm.

11. Device (10) for implementing the method for managing alarms in accordance with fault currents in an electrical facility according to any of the previous claims, device including a differential current sensor (2) arranged to measure permanently the differential fault current (IΔn) of said facility, an earth leakage current sensor (8) arranged to measure permanently the earth fault current (Ipe) of said facility, a checking module (3) arranged to compare each measured fault current with a permissible fault current threshold, and a control unit (4) for an alarm (5) arranged to trigger an alarm when said threshold is exceeded, device **characterized in that** it moreover includes a parameterizing unit (16) arranged to determine for every measured fault current (IΔn, Ipe) at least two different fault current thresholds that are adapted to at least two different load current values of said facility, a calculation module (17) that communicates on the one hand with said parameterizing unit (16) and on the other hand with said checking module (3), and a device (11) that measures the instantaneous load current of said facility and communicates with said calculation module (17).

12. Device according to claim 11, **characterized in that** said measuring device (11) includes a current sensor on each conductor of the electrical facility to measure the current in each of said conductors, and communicates with said calculation module (17) arranged to calculate the average of the currents measured on said conductors and determine said load current of the facility.

13. Device according to claim 11, **characterized in that** said fault current sensors (2, 8) are coupled with amplifiers in order to achieve a maximum accuracy in a wide measuring range that extends from 5mA to 30A.

14. Device according to claim 11, **characterized in that** said parameterizing unit (16) includes at least a display and a keyboard to communicate with a user and allow him to store at least two different permissible fault current thresholds in function of two different load current values of said facility.

15. Device according to claim 11, **characterized in that** it moreover includes a communication bus (18) arranged to communicate with a remote monitoring station.
